(19)

Europäisches
Patentamt

European
Patent Office

Office européen
des brevets

(11) **EP 2 560 202 A2**

(12) **EUROPEAN PATENT APPLICATION**

(43) Date of publication:
  **20.02.2013 Bulletin 2013/08**

(51) Int Cl.:
  ***H01L 23/367*** (2006.01)

(21) Application number: **12177411.1**

(22) Date of filing: **23.07.2012**

(84) Designated Contracting States:
  **AL AT BE BG CH CY CZ DE DK EE ES FI FR GB
  GR HR HU IE IS IT LI LT LU LV MC MK MT NL NO
  PL PT RO RS SE SI SK SM TR**
  Designated Extension States:
  **BA ME**

(30) Priority: **16.08.2011 KR 20110081017**

(71) Applicant: **LSIS Co., Ltd.**
  **Dongan-gu, Anyang-si
  Gyeonggi-do 431-080 (KR)**

(72) Inventors:
  • **Kim, Min Jee**
   **120-110 Seoul (KR)**

• **Sim, Jung Wook**
 **361-858 Chungcheongbuk-do (KR)**
• **Choe, Won Joon**
 **361-270 Chungcheongbuk-do (KR)**
• **Lee, Gyeong Ho**
 **361-300 Chungcheongbuk-do (KR)**
• **Bang, Seung Hyun**
 **361-864 Chungcheongbuk-do (KR)**
• **Park, Hae Yong**
 **631-150 Gyeongsangnam-do (KR)**

(74) Representative: **Löfgren, Håkan Bengt Alpo**
  **Groth & Co KB
  Box 6107
  102 32 Stockholm (SE)**

(54) **Heat sinking plate**

(57)  Provided is a heat sinking plate, the plate comprising a metal plate with a crown-shaped structure by erecting four triangles obtained by diagonally and crossly cutting a square of a predetermined length to one direction of the metal plate at a predetermined first angle relative to the metal plate, and with a square-shaped opening of the predetermined length when viewed from the other direction of the metal plate.

FIG. 1

## Description

## BACKGROUND OF THE DISCLOSURE

### Field of Endeavor

The present disclosure relates to a heat sinking plate, and more particularly to a heat sinking plate to be used for radiation of heat in electronic elements such as fault current limiter.

### Background

This section provides background information related to the present disclosure which is not necessarily prior art.

In general, air cooling type includes two types: a natural convection and a forced convection. The former uses a fan to control wind speed and wind direction and needs no choosy installation condition for heat sinking plates.

Meanwhile, heat sink plates are largely stacked horizontally in the natural convection in consideration of characteristics of air circulated by difference of air density. In a case where the heat sink plates are not horizontally arranged due to restrictions caused by structural characteristics, insulation distance and installation space, punctured metal plates are vertically stacked to obtain same heat transfer area and vertical air circulation paths as those of metal plates prior to punctuation.

Meanwhile, heat sinking plates are employed for cooling of many electrical power devices. Particularly, the heat sinking plates used in the electrical power devices carry several drawbacks such as spatial restriction in installation in view of importance of obtaining an insulation distance.

### SUMMARY OF THE DISCLOSURE

This section provides a general summary of the disclosure, and is not a comprehensive disclosure of its full scope or all of its features.

The present disclosure has been made to solve the foregoing problem(s) of the prior art, and therefore an object of certain embodiments of the present invention is to provide a heat sinking plate configured to improve each shape of metal plate to allow vertical stacking of the metal plate, and to optimize a size of a system for maximization of radiation efficiency.

In one general aspect of the present disclosure, there is provided A heat sinking plate, the heat sinking plate comprising a metal plate with a crown-shaped structure by erecting four triangles obtained by diagonally and crossly cutting a square of a predetermined length to one direction of the metal plate at a predetermined first angle relative to the metal plate, and with a square-shaped opening of the predetermined length when viewed from the other direction of the metal plate.

Preferably, but not necessarily, the opening is formed at a second angle relative to the rectangular metal plate.

Preferably, but not necessarily, the second angle is substantially 45°.

Preferably, but not necessarily, a plurality of openings is formed, each spaced apart from the other at a same space.

Preferably, but not necessarily, a length of the opening is substantially same as the space.

In another general aspect of the present disclosure, there is provided A heat sinking plate, the heat sinking plate comprising a metal plate with a crown-shaped structure by erecting four triangles obtained by diagonally and crossly cutting a square of a predetermined length to one direction of the metal plate at a predetermined first angle relative to the metal plate, and with a square-shaped opening of the predetermined length when viewed from the other direction of the metal plate, wherein a plurality of openings is formed, each opening spaced apart at a same space to every direction, and the plurality of metal plates is stacked.

Preferably, but not necessarily, a length of the opening is substantially same as the space, and stacked to allow the openings to be alternatively positioned.

Preferably, but not necessarily, the opening is formed at a second angle relative to the rectangular metal plate.

Preferably, but not necessarily, the second angle is substantially 45°.

The heat sinking plate according to the present disclosure has an advantageous effect in that a system can be greatly reduced while a heat transfer area of a metal plate is same as that prior to punctuation.

### BRIEF DESCRIPTION OF THE DRAWINGS

In order to explain the principle of the present disclosure, some accompanying drawings related to its preferred embodiments are below reported for the purpose of illustration, exemplification and description, although they are not intended to be exhaustive. The drawing figures depict one or more exemplary embodiments in accord with the present concepts, by way of example only, not by way of limitations. In the figures, like reference numerals refer to the same or similar elements.

Thus, a wide variety of potential practical and useful embodiments will be more readily understood through the following detailed description of certain exemplary embodiments, with reference to the accompanying exemplary drawings in which:

FIG. 1 is a plan view illustrating a heat sinking plate according to an exemplary embodiment of the present disclosure;
FIG.2a is a schematic perspective view illustrating a rear surface of a circular area formed by dotted lines of FIG.1;

FIG.2b is a schematic lateral view of FIG.2a according to an exemplary embodiment of the present disclosure; and
FIG.3 is a schematic view illustrating a stacked structure with heat sinking plates according to the present disclosure.

## DETAILED DESCRIPTION

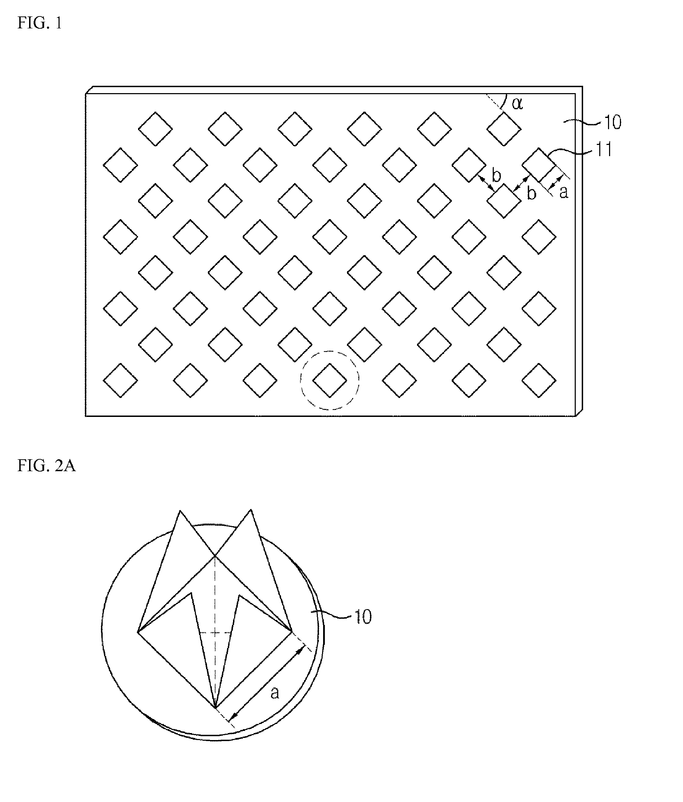

The disclosed embodiments and advantages thereof are best understood by referring to FIGS. 1-3 of the drawings, like numerals being used for like and corresponding parts of the various drawings. Other features and advantages of the disclosed embodiments will be or will become apparent to one of ordinary skill in the art upon examination of the following figures and detailed description. It is intended that all such additional features and advantages be included within the scope of the disclosed embodiments, and protected by the accompanying drawings. Further, the illustrated figures are only exemplary and not intended to assert or imply any limitation with regard to the environment, architecture, or process in which different embodiments may be implemented. Accordingly, the described aspect is intended to embrace all such alterations, modifications, and variations that fall within the scope and novel idea of the present invention.

Meanwhile, the terminology used herein is for the purpose of describing particular implementations only and is not intended to be limiting of the present disclosure. The terms "first," "second," and the like, herein do not denote any order, quantity, or importance, but rather are used to distinguish one element from another. For example, a second constituent element may be denoted as a first constituent element without departing from the scope and spirit of the present disclosure, and similarly, a first constituent element may be denoted as a second constituent element.

As used herein, the terms "a" and "an" herein do not denote a limitation of quantity, but rather denote the presence of at least one of the referenced item. That is, as used herein, the singular forms "a", "an" and "the" are intended to include the plural forms as well, unless the context clearly indicates otherwise.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Also, "exemplary" is merely meant to mean an example, rather than the best. If is also to be appreciated that features, layers and/or elements depicted herein are illustrated with particular dimensions and/or orientations relative to one another for purposes of simplicity and ease of understanding, and that the actual dimensions and/or orientations may differ substantially from that illustrated. That is, in the drawings, the size and relative sizes of layers, regions and/or other elements may be exaggerated or reduced for clarity. Like numbers refer to like elements throughout and explanations that duplicate one another will be omitted. As may be used herein, the terms "substantially" and "approximately" provide an industry-accepted tolerance for its corresponding term and/or relativity between items.

Hereinafter, a heat sinking plate according to the present disclosure will be described in detail with reference to the accompanying drawings.

FIG. 1 is a plan view illustrating a heat sinking plate according to an exemplary embodiment of the present disclosure.

Referring to FIG.1, the heat sinking plate according to the present disclosure is formed by a plurality of square-shaped openings (11), each opening having a predetermined length (a), by punctuating a metal plate (10), wherein each of the plurality of openings is discrete from the other opening on a straight line, each opening spaced apart at a predetermined gap (b).

Each of the plurality of openings (11) is punched with a predetermined angle ($\alpha$) relative to the rectangular metal plate (10), and preferably, each opening is punched at an angle of 45° relative to the rectangular metal plate (10).

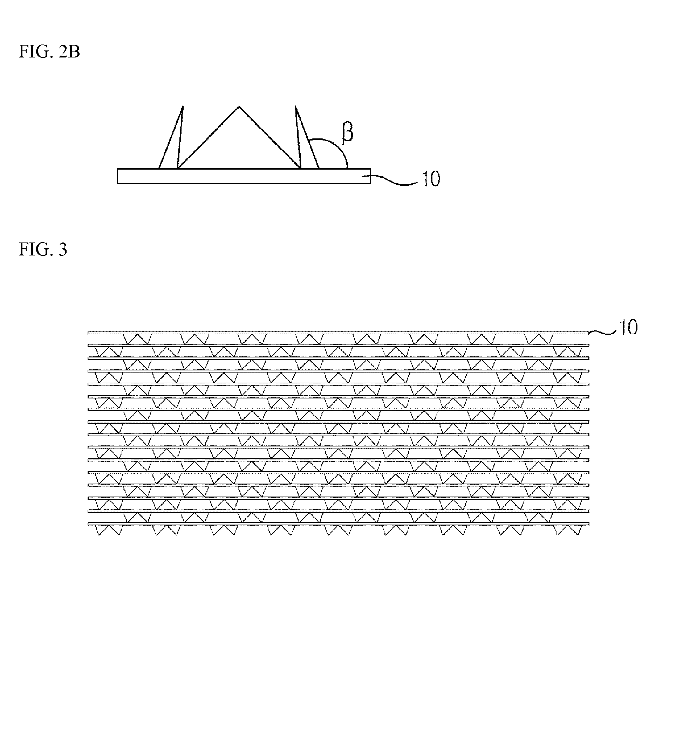

FIG.2a is a schematic perspective view illustrating a rear surface of a circular area formed by dotted lines of FIG.1, and FIG.2b is a schematic lateral view of FIG.2a according to an exemplary embodiment of the present disclosure.

Referring to FIGS.2a and 2b, a same heat transfer area as that of the metal plate before the punctuation can be obtained by preserving and not disposing a crown-shaped structure generated in the course of punching the opening (11). That is, a square on a rectangular metal plate (10) is diagonally and crossly cut off to obtain four triangles, where the four triangles are erected to one direction of the metal plate (10) at a predetermined angle ($\beta$) to form a crown-shaped structure, wherein an opening (11) is formed in the other direction. The sizes of four triangles obtained by punching the metal plate are as under:

Assuming that a length of a side of the opening (11) in FIG.1 is 'a', it should be apparent that a length of a base of the triangle is 'a', and each length of the other two sides excluding the base is $\frac{\sqrt{2}}{2}$ a, and a height of the triangle is $\frac{a}{2}$.

The heat sinking plate thus configured according to the present disclosure can structurally maintain the same heat transfer area as that prior to punctuation to the metal plate, and can smoothly and rapidly dissipate the heat by vertical circulation of air through the openings (11) formed by the punctuation.

FIG.3 is a schematic view illustrating a stacked structure with heat sinking plates according to the present disclosure.

Referring to FIG.3, a crown-shaped structure formed by cutting the metal plate corresponding to each opening (11) functions to maintain a gap between the metal plate (10). Referring again to FIG.3, a gap between the openings (11) is made same as a length of one side of the opening (11), that is, a gap as large as 'a' is formed (i.e., b=a), where the opening (11) of each metal plate (10) may be alternatively positioned and stacked.

The heat sinking plate according to the present disclosure may be used for cooling an IGBT (Insulated Gate Bipolar Transistor), where an expected heating value of IGBT used for a 24Kv/4,000A/40kA standard fault current limiter may be approximately 48kW.

The heat sinking plate according to the present disclosure may greatly reduce a size of a system through obtainment of a heat transfer area same as that of a metal plate prior to the punctuation. The heat sinking plate according to the present disclosure may be used for increasing radiation efficiency and optimizing a size of a system and a distributing board, in a case where a power conversion device such as an IGBT is to be cooled using air cooling type or a heat pipe.

The fault current limiter using the IGBT may adopt an air cooling type, a heat pipe cooling type and/or water cooling type depending on heating value. An air cooling type using a heat sinking plate or heat pipe may be used for a relatively small heating value. Arrangement and structure of the heat sinking plate may vary depending on use of cooling fan (i.e., forced cooling or natural convection cooling), and in a case of using the punched heat sinking plate, restriction of structural system may be lessened by vertically stacking the heat sinking plates even in the natural convection type.

That is, use of the heat sinking plate according to the present disclosure can remarkably reduce the size of a system by obtaining same heat transfer area as that of a metal plate before the punctuation.

Although the present disclosure has been described with reference to a number of illustrative embodiments thereof, it should be understood that numerous other modifications and embodiments can be devised by those skilled in the art that will fall within the spirit and scope of the principles of this disclosure.

More particularly, various variations and modifications are possible in the component parts and/or arrangements of subject combination arrangement within the scope of the disclosure, the drawings and the appended claims. In addition to variations and modifications in the component parts and/or arrangements, alternative uses will also be apparent to those skilled in the art.

**Claims**

1. A heat sinking plate, the heat sinking plate comprising a metal plate (10) with a crown-shaped structure by erecting four triangles obtained by diagonally and crossly cutting a square of a predetermined length to one direction of the metal plate (10) at a predetermined first angle ($\beta$) relative to the metal plate (10), and with a square-shaped opening (11) of the predetermined length (a) when viewed from the other direction of the metal plate (10).

2. The heat sinking plate of claim 1, wherein the opening (11) is formed at a second angle ($\alpha$) relative to the rectangular metal plate (10).

3. The heat sinking plate of claim 2, wherein the second angle ($\alpha$) is substantially 45°.

4. The heat sinking plate of any one claim from 1, 2 and 3, wherein a plurality of openings (11) is formed, each spaced apart from the other at a same space (b).

5. The heat sinking plate of claim 4, wherein a length (a) of the opening (11) is substantially same as the space (b).

6. A heat sinking plate, the heat sinking plate comprising a metal plate (10) with a crown-shaped structure by erecting four triangles obtained by diagonally and crossly cutting a square of a predetermined length to one direction of the metal plate (10) at a predetermined first angle ($\beta$) relative to the metal plate (10), and with a square-shaped opening (11) of the predetermined length (a) when viewed from the other direction of the metal plate (10), wherein a plurality of openings (11) is formed, each opening (11) spaced apart at a same space (b) to every direction, and the plurality of metal plates (10) is stacked.

7. The heat sinking plate of claim 6, wherein a length (a) of the opening (11) is substantially same as the space (b), and stacked to allow the openings (11) to be alternatively positioned.

8. The heat sinking plate of claim 6 or 7, wherein the opening (11) is formed at a second angle ($\alpha$) relative to the rectangular metal plate (10).

9. The heat sinking plate of claim 8, wherein the second angle ($\alpha$) is substantially 45°.

FIG. 1

FIG. 2A

FIG. 2B

FIG. 3